# EUROPEAN PATENT APPLICATION

(11) **EP 2 830 085 A1**
(43) Date of publication of application: **28.01.2015**
(21) Application number: 13765262.4
(22) Date of filing: 15.03.2013
(51) Int. Cl.: H01L 21/28, B23K 26/00, H01L 29/417

(54) **SEMICONDUCTOR DEVICE AND METHOD FOR MANUFACTURING SAME**

(30) Priority: 22.03.2012 JP 2012064707
(71) Applicant: Aisin Seiki Kabushiki Kaisha, Kariya-shi, Aichi 448-8650 (JP)
(72) Inventor: TANIGAWA, Tatsuya, Kariya-shi, Aichi 448-8650 (JP); OTA, Michiharu, Kariya-shi, Aichi 448-8650 (JP)
(74) Representative: TBK
(86) International application number: PCT/JP2013/001761
(87) International publication number: WO 2013/140764

(57) **Abstract**

The present invention aims at providing a semiconductor device having a conductive film formed on a semiconducting substrate so that heating of the substrate and contamination by impurities can be suppressed and Schottky resistance can be reduced, and at providing a method of manufacturing the same. The metal film formation method used in manufacturing the semiconductor device according to an embodiment of the present invention includes the steps of: irradiating one surface of the substrate with a femtosecond laser having energy in the vicinity of the processing threshold value to form a nano-periodic structure in the form of minute irregularities; and forming a metal film on the nano-periodic structure of the substrate. It is thereby possible to reduce the Schottky resistance at the interface between the substrate and the metal film and obtain an ohmic contact while suppressing heating of the substrate and contamination by impurities.

## Description

### Technical Field

The present invention relates to a semiconductor device having a conductive film formed on a semiconducting substrate, and to a method of manufacturing the same.

### Background Art

When a metal film is formed on a semiconducting substrate, at the interface between the semiconducting substrate and the metal film (referred to as a semiconductor/metal interface), Schottky resistance is generated. Therefore, in order to use the metal film formed on the semiconducting substrate as an ohmic electrode, it is necessary to reduce the Schottky resistance to thereby form an ohmic contact at the semiconductor/metal interface. As a method of reducing the Schottky resistance, a general method is to perform annealing at high temperatures after forming an electrode. Further, as a method of further reducing the resistance, there is known such a technique as, after making the surface of the semiconducting substrate rough, that is, after forming minute irregularities on a substrate surface, forming a metal film on the substrate surface. In addition, there is known such a technique as, after performing ion implantation into a surface of a semiconducting substrate, forming a metal film on the substrate surface.

In Patent Literature 1, there is described a method of performing a grinding treatment with a whetstone or a mechanical processing by sandblast etc. on a substrate surface to thereby form irregularities on the substrate surface. In Patent Literature 2, there is described a method of performing laser irradiation onto a substrate surface to thereby heat the substrate surface and form irregularities.

### Citation List

### Patent Literature

PTL 1: Japanese Patent Application Laid-Open No. 2009-283754
PTL 2: Japanese Patent Application Laid-Open No. 2006-41248

### Summary of Invention

### Technical Problem

In the method disclosed in Patent Literature 1, breakage or crack may be generated when performing a mechanical processing of the surface at high speed in a case where a hard and brittle substrate such as SiC or GaN is used in particular, and, in order to prevent it, it is necessary to perform the treatment at low speed. Further, since a whetstone or sandblast particles contact with the substrate surface in the processing, an impurity may contaminate the semiconductor/metal interface.

In the method disclosed in Patent Literature 2, irregularities are formed on a substrate surface by heating the substrate up to a temperature of melting point or higher by laser irradiation. When a material having a high melting point such as SiC or GaN is used for a substrate in particular, since it is necessary to heat the substrate to high temperatures, there is such a problem that the application to a structure that is weak against heat is difficult.

In a method of performing annealing at high temperatures after forming an electrode, or in a method of performing ion implantation onto a substrate surface, since it is necessary to heat the substrate at high temperatures, there is such a problem that the application to a structure that is weak against heat is also difficult.

As described above, conventionally, there are various problems in a semiconductor device having a conductive film formed on a semiconducting substrate. The present invention aims at providing a semiconductor device in which these problems have been improved and a method of manufacturing the same.

### Solution to Problem

A first aspect of the present invention is a method of manufacturing a semiconductor device having a conductive film formed on a semiconducting substrate, the method including a surface modification step of irradiating a surface of the semiconducting substrate with a femtosecond laser to form a surface-modified region on the surface of the semiconducting substrate; and a conductive-film forming step of forming the conductive film on the surface-modified region.

A second aspect of the present invention is a semiconductor device, including a semiconducting substrate, a surface-modified region formed on a surface of the semiconducting substrate by irradiating the surface of the semiconducting substrate with a femtosecond laser, and a conductive film formed on the surface-modified region.

### Advantageous Effects of Invention

According to the method of the present invention, when a conductive film is to be formed on a semiconducting substrate, damage to the substrate caused by heating, contamination by impurities etc. can be suppressed and the Schottky resistance can be reduced.

### Brief Description of Drawings

Fig. 1A is a drawing showing a process for forming a metal film according to one embodiment of the present invention.
Fig. 1B is a drawing showing a process for forming a metal film according to one embodiment of the present invention.
Fig. 1C is a drawing showing a process for forming a metal film according to one embodiment of the present invention.
Fig. 2 is an outline view showing a nano-periodic structure-forming apparatus according to one embodiment of the present invention.
Fig. 3A is a drawing showing a resistance measurement method in one Example of the present invention.
Fig. 3B is a drawing showing a resistance measurement method in Comparative Example.
Fig. 4A is a drawing showing a resistance measurement method in one Example of the present invention.
Fig. 4B is a drawing showing a resistance measurement method in Comparative Example.
Fig. 5A is a schematic cross-sectional view showing an application example of the present invention.
Fig. 5B is a schematic cross-sectional view showing an application example of the present invention.
Fig. 5C is a schematic cross-sectional view showing an application example of the present invention.
Fig. 6 is a drawing showing an exemplary nano-periodic structure.

### Description of Embodiments

Hereinafter, embodiments of the present invention will be described with reference to the drawings, but the present invention shall not be limited to the embodiments. Meanwhile, in the drawings described below, the same reference numeral is given to those having the same function, and the repeated explanation thereof will be omitted.

### (Embodiment)

It is known that irradiating a surface of a material with a femtosecond laser with a certain energy or more makes it possible to evaporate the material (referred to as ablation) while suppressing heating of the surface of the substrate. The value of the energy is referred to as a processing threshold value. Further, there is known such a phenomenon that irradiating a surface of a substrate such as a metal or semiconductor with a femtosecond laser with an energy in the vicinity of the processing threshold value of the substrate generates ablation in a stripe shape with a cycle close to the wavelength of the femtosecond laser.

The present inventor utilized the phenomenon, and found that Schottky resistance could be reduced by irradiating a substrate with a femtosecond laser with an energy in the vicinity of the processing threshold value to thereby form nano-level periodic irregularities (referred to as a nano periodic structure) on the substrate and forming a metal film thereon.

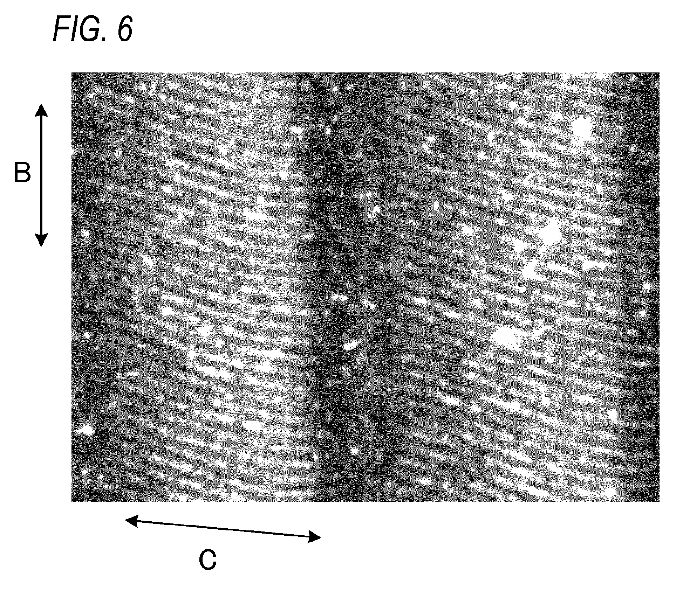

Fig. 6 is an exemplary image obtained by photographing the surface of the nano-periodic structure formed on a substrate with an SEM. A femtosecond laser is scanned along a B direction, and it is revealed that irregularities extending along a C direction are formed periodically. Meanwhile, since the C direction that is the direction of periodic irregularities depends on a polarizing direction of the femtosecond laser, the C direction can be varied arbitrarily by altering the polarizing direction. Here, a femtosecond laser having a wavelength of 1.05 µm is used, and each of grooves included in the irregularities has a width of around 700 nm and a depth of around 200 nm.

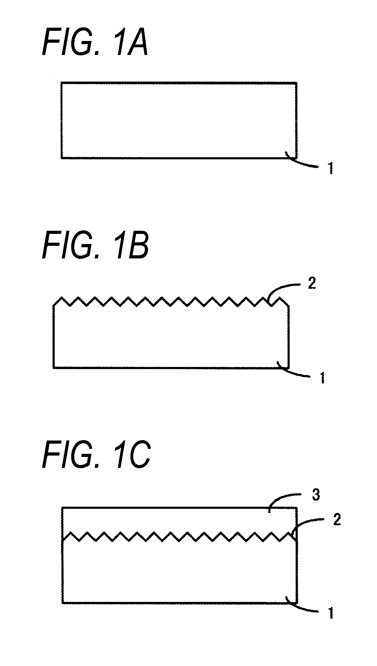

Figs. 1A to 1C are drawings showing a method of forming a metal film on a semiconducting substrate for use in manufacturing the semiconductor device according to the embodiment. A first process shown in Fig. 1A prepares a semiconducting substrate 1 that is an object for which a film is to be formed. As the substrate 1, an SiC substrate is used. It is known that, in an SiC substrate, one surface is a C plane in which C atoms are arrayed on the surface and the other surface facing the one surface is a Si plane in which Si atoms are arrayed on the surface, and a metal film is to be formed on the C plane in the embodiment. Conventionally, it has been recognized that the reduction of the Schottky resistance in forming a metal film is difficult in particular for the C plane of an SiC substrate. This is because, in a conventional technique in which the Schottky resistance is to be reduced by performing annealing at high temperatures after forming a metal film, the C atom is precipitated on the C plane by being heated to high temperatures to thereby deteriorate the adhesiveness of the metal film. In contrast, in the method of forming a metal film according to the present invention, since an ohmic contact can be obtained even when conventional annealing at high temperatures is not performed after forming a metal film, the method can be applied favorably also to the C plane of an SiC substrate.

The method of forming a metal film according to the embodiment can be applied not only to the C plane of an SiC substrate but also to the Si plane of the SiC substrate. Further, it can be applied also to a GaN substrate and a diamond semiconductor substrate having a high melting point and high hardness.

A second process shown in Fig. 1B forms a nano-periodic structure 2 in the form of minute irregularities by irradiating one surface of the substrate 1 (the C plane of the SiC substrate) with a femtosecond laser having an energy in the vicinity of the processing threshold value of the substrate 1. The nano-periodic structure 2 can be formed for at least a region including a range on which a metal film is to be formed, by scanning the femtosecond laser.

A third process shown in Fig. 1C forms a metal film 3 on the nano-periodic structure 2 of the substrate 1.

In the embodiment, the metal film is formed by depositing Cr. In addition to the method, any method such as a CVD method, sputtering method, electroplating method or the like may be used, only if the metal film 3 can be formed on the nano-periodic structure 2. Further, as the metal film 3, any metal that shows the Schottky resistance by contacting with the substrate 1 can be used.

By manufacturing a semiconductor device having the metal film 3 formed on the substrate 1 using the method of forming a metal film shown in Figs. 1A to 1C, it is possible to suppress substrate heating and impurity contamination and to ohmic-contact the substrate 1 and the metal film 3 by reducing the Schottky resistance at the interface between the substrate 1 and the metal film 3, even not performing high-temperature annealing. In particular, when the metal film 3 is to be formed on the C plane of the SiC substrate, it is possible to suppress the generation of exfoliation of the metal film 3 caused by the precipitation of C atoms at the semiconductor/metal interface by high-temperature annealing.

After the process of forming the metal film 3 shown in Fig. 1C, annealing may be performed at such low temperatures that do not cause the C atom to be precipitated at the interface between the substrate 1 and the metal film 3 using a heating furnace or a laser. Consequently, the effect of further reducing the Schottky resistance can be obtained.

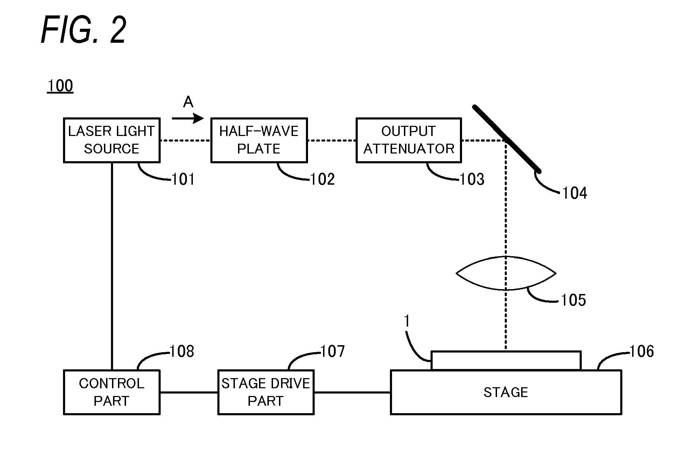

Fig. 2 is an outline view of a nano-periodic structure-forming apparatus 100 for forming the nano-periodic structure on a substrate. In Fig. 2, the connection between devices is shown with a solid line and the light path of laser light is shown with a broken line. The nano-periodic structure-forming apparatus 100 includes laser light source 101 that emits laser light A being a femtosecond laser, a half-wave plate that controls the polarizing direction of the laser light A, an output attenuator that adjusts the output of the laser light A, a mirror 104 that changes the light path of laser light A, a condenser lens 105 that condenses the laser light A, a stage 106 for placing the substrate 1, and a stage drive part 107 that moves the position of the stage 106. Furthermore, a control part 108 that controls the laser light source 101 and stage drive part 107 is provided.

The laser light source 101 emits the laser light A being a femtosecond laser. In the embodiment, as the laser light source 101, a laser oscillator having a frequency of 100 kHz, a central wavelength of 1.05 µm, an output of 1 W, and a pulse width of 500 fs is used. Laser emission conditions of the laser light source 101 may be adjusted arbitrarily. In the embodiment, if the nano-periodic structure can be formed, the laser light A may not be a femtosecond laser but may be a picosecond laser.

In the direction in which the laser light A is emitted from the laser light source 101, a half-wave plate 102 that adjusts the polarizing direction of the laser light A being a linearly-polarized light is provided. The half-wave plate 102 is configured to be rotatable, and, by rotating the half-wave plate 102, the polarizing direction of the laser light A can be altered arbitrarily. Furthermore, in the direction in which the laser light A is emitted from the half-wave plate 102, an output attenuator 103 that adjusts the output of the laser light A is provided.

As the output attenuator 103, for example, a polarizing beam splitter can be used. The polarizing beam splitter has a function of splitting incident light into two directions according to the polarizing direction, and, when the polarizing direction of the laser light A is altered by rotating the half-wave plate 102, the splitting ratio of the laser light A in the polarizing beam splitter is varied. Accordingly, by adjusting the half-wave plate 102 and the output attenuator 103 being a polarizing beam splitter, the output of the laser light A to be irradiated to the substrate can be attenuated. Meanwhile, if the output of the laser light A can be attenuated, any means can be applied without limitation to the combination of the half-wave plate and the polarizing beam splitter.

In the embodiment, the output of the laser light A is attenuated to 0.1 W by the output attenuator 103, but appropriate adjustment is allowable.

Furthermore, in one of directions in which the laser light A is output from the output attenuator 103, a mirror 104 for altering the direction of the laser light A to the substrate, and a condenser lens 105 for narrowing down a spot are provided. The mirror 104 may be omitted, or may be provided in plurality on the light path. The condenser lens 105 may be any lens, and a lens having an NA of 0.2 is used in the embodiment. The laser light A condensed by the condenser lens 105 is irradiated toward the substrate 1. Meanwhile, in the embodiment, the laser light is irradiated to the substrate using the mirror and the condenser lens, but the laser light may be scanned over the entire region of the substrate surface using a galvanoscanner.

Further, a cylindrical lens may be used to form laser light into a line shape and the laser light may be irradiated to a large area of the substrate surface. Further, a diffractive optical element (DOE) may be used to split laser light into a plurality of lights and the plurality of laser lights may be irradiated simultaneously to the substrate surface.

The substrate 1 is placed on the stage 106 that is movable in any direction by the stage drive part 107. When the stage drive part 107 moves the stage 106 parallel to the surface of the substrate 1, the laser light A can scan the surface of the substrate 1. In the embodiment, the scanning speed is set to be 100 mm/s, but it may be adjusted appropriately. Further, when the stage drive part 107 moves the stage 106 in the normal direction of the surface of the substrate 1, the spot diameter of the laser light A on the surface of the substrate 1 can be varied.

Furthermore, a control part 108 for controlling the laser light source 101 and the stage drive part 107 is provided. The control part 108 can control cooperatively the start and stop of the laser light A irradiation, and the movement of the stage 106 by the stage drive part 107. The control part 108 includes desirably a display part for displaying information and an input part for accepting input such as a start instruction, stop instruction etc. from a user. Furthermore, a memory part for storing laser emission conditions and laser irradiation range may be provided in the control part 108.

Meanwhile, without providing the control part 108, a user may operate the laser light source 101 and the stage drive part 107.

When the nano-periodic structure-forming apparatus 100 is to be used, the energy of the laser light A is adjusted to a vicinity of the processing threshold value of the substrate 1 by altering the laser emission condition of the laser light source 101, the attenuation ratio of the laser light A by the half-wave plate 102 and the output attenuator 103, and the spot diameter of the laser light A. Thereby, in a range where the laser light A is irradiated on the surface of the substrate 1, the nano-periodic structure is formed. Meanwhile, in the embodiment, a Gaussian beam is irradiated, but a beam having a uniform light strength in the whole area of the beam spot may be formed using a DOE or the like and the beam may be irradiated.

Hereinafter, one example of the nano-periodic structure formation operation according to the embodiment will be described.

First, a user adjusts the energy when the laser light A is to be irradiated to the substrate 1 to the vicinity of the processing threshold value of the substrate 1 by adjusting laser emission conditions of the laser light source 101, the attenuation ratio of the laser light A by the half-wave plate 102 and the output attenuator 103, and the spot diameter of the laser light A.

The user performs, after arranging the substrate 1 on the stage 106, a start instruction for the control part 108 from the input part. When receiving the start instruction, the control part 108 starts laser irradiation from the laser light source 101 and, at the same time, controls the stage drive part 107 to start the movement of the stage 106. Along with the movement of the stage 106, the nano-periodic structure is formed continuously in the spot of the laser light A on the surface of the substrate 1.

The laser light A may be scanned over the whole area that is to be irradiated with laser by moving the stage 106 linearly and performing the movement plural times in parallel. Alternatively, the stage 106 may be moved circularly. It is desirable to scan the laser light A so that a locus of the spot irradiated with the laser light A does not overlap.

The area that is to be irradiated with laser may be preprogramed in the control part 108, or may be set in the control part 108 by a user at the start of processing.

After forming the nano-periodic structure in the whole area that is to be irradiated with laser, the control part 108 automatically stops the laser irradiation from the laser light source 101 and the movement of the stage 106 by the stage drive part 107. Alternatively, the user may perform a stop instruction for the control part 108 from the input part to thereby stop the processing.

In the above nano-periodic structure formation operation, an example in which the control part 108 controls the movement of the stage 106 is shown, but a user may perform the start and stop of laser irradiation, and the movement of the stage 106.

### (Example 1)

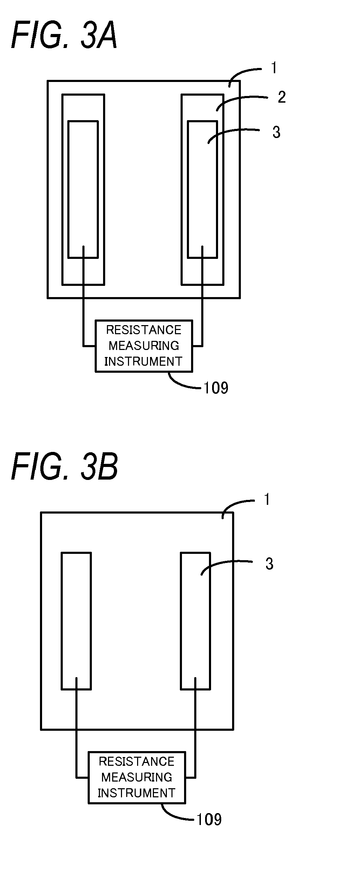

For a metal electrode formed by using the method of forming a metal film shown in Figs. 1A to 1C, an experiment of measuring resistance was performed. In Fig. 3A, the configuration of the Example is shown. In the Example, two nano-periodic structures 2 are formed in separate places on the substrate 1, and the metal film 3 is formed on each of the nano-periodic structures 2. To the two metal films 3, a resistance measuring instrument 109 is connected via a lead wire. The substrate 1 is an SiC substrate, and the metal film 3 is a Cr film. The nano-periodic structure 2 is formed on the C plane of the SiC substrate using the nano-periodic structure-forming apparatus 100 shown in Fig. 2. In Fig. 3B, a configuration in Comparative Example is shown. The configuration in Comparative Example is the same as that in the Example, except that no nano-periodic structure 2 is formed and two metal films 3 are directly formed in separate places on the substrate 1.

For the Example, a resistance value was measured four times while altering the connection spot of the resistance measuring instrument 109 to thereby give 0.15 MkΩ, 0.25 MΩ, 0.30 MΩ and 0.35 MΩ. Further, for Comparative Example, a resistance value was measured four times while altering the connection spot of the resistance measuring instrument 109 to thereby give 0.85 MΩ, 0.85 MΩ, 0.86 MΩ and 0.86 MΩ.

As a result, it was revealed that the resistance value was reduced up to around 1/5 in the Example having such a configuration that the nano-periodic structure was formed at the semiconductor/metal interface as compared with Comparative Example that had no such configuration. The measured resistance value is the sum of a contact resistance (resistance between the substrate 1 and the metal film 3) and a sheet resistance (resistance between two metal films 3 on the substrate 1) and, therefore, it is considered that, when taking account of the contact resistance alone, that is, the Schottky resistance at the semiconductor/metal interface, the resistance is furthermore largely reduced.

In the Example, the aspect ratio of the nano-periodic structure 2 is around 3:1 (width of 700 nm, depth of 200 nm) and, therefore, the increase rate of the contact area of the semiconductor/metal interface is at most 20 to 30%. Accordingly, when taking into account that the contact resistance has been reduced to less than 1/5, it is considered that a factor other than the increase in the contact area takes part complexly. For example, it is considered that the C atom of the C plane of the SiC substrate is removed when the nano-periodic structure has been formed by the femtosecond laser irradiation to thereby expose the Si atom and a dangling bond has increased. Further, it is considered that the crystal structure of the substrate surface has been changed by the femtosecond laser irradiation.

### (Example 2)

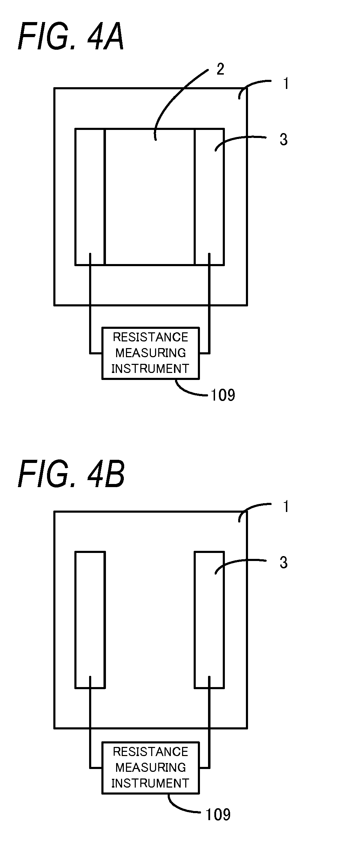

In order to check out that the property of the substrate surface, on which the nano-periodic structure has been formed, has been changed, an experiment was performed, in which the nano-periodic structure was formed between electrodes instead of at the semiconductor/metal interface and the resistance was measured. The configuration of the Example is shown in Fig. 4A. In the Example, the nano-periodic structure 2 is formed on the substrate 1, and, so as to sandwich the nano-periodic structure 2 from two directions parallel to the surface of the substrate 1, two metal films 3 are formed on the substrate 1. To the two metal films 3, the resistance measuring instrument 109 is connected via a lead wire. The substrate 1 is an SiC substrate, and the metal film 3 is a Cr film. The nano-periodic structure 2 is formed on the C plane of the SiC substrate using the nano-periodic structure-forming apparatus 100 shown in Fig. 2. In Fig. 4B, the configuration of Comparative Example is shown. The configuration of Comparative Example is the same as that of the Example, except that no nano-periodic structure 2 is formed between the two metal films 3.

For the Example, the resistance value was measured to give 0.08 MΩ. Further, for Comparative Example, the resistance value was measured to give 1.9 MΩ.

As a result, it was revealed that the resistance was reduced largely in the Example having such a configuration that the nano-periodic structure was formed on the substrate surface between the two metal films 3 as compared with Comparative Example that had no such configuration.

By the Example, it was confirmed that, in the region where the nano-periodic structure was formed on the substrate surface, not only the surface area has increased simply but also the crystal structure of the substrate surface has changed to thereby show a property of semi-metallic state having low resistance.

When taking into account results of respective Examples, it can be presumed that, when a femtosecond laser is irradiated to a substrate surface, a surface-modified region including a nano-periodic irregular structure and a region having reduced resistance is formed on the substrate surface. It is considered that, as a result, a more remarkable effect of reducing the Schottky resistance can be actualized when a metal film is formed on the surface-modified region.

### (Application example)

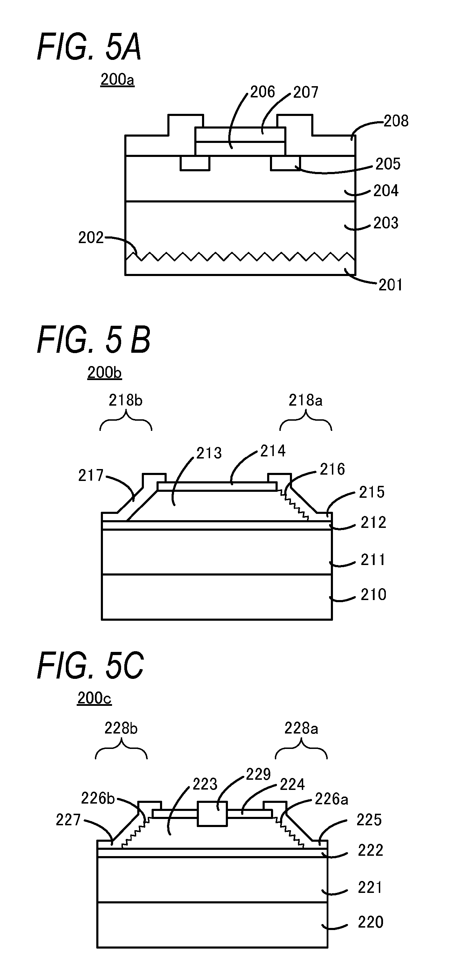

In Figs. 5A to 5C, examples of devices that are configured by applying the present invention are shown.

Fig. 5A is a schematic cross-sectional view of an exemplary vertical type Schottky barrier diode (SBD) 200a. In the vertical type SBD 200a, an n⁻ type SiC layer 204 is stacked on one surface (Si plane) of an n⁺ type SiC layer 203. On the surface (Si plane) of the n⁻ type SiC layer 204, a Schottky electrode 206 is formed and, on the Schottky electrode 206, a wiring electrode 207 is formed. Furthermore, the device is covered with an insulating film 208 so as to cover the n⁻ type SiC layer 204, the Schottky electrode 206 and the wiring electrode 207. Via an opening owned by the insulating film 208, a part of the wiring electrode 207 is exposed. In parts that are in contact with both ends of the Schottky electrode 206 in the n⁻ type SiC layer 204, a p type SiC layer 205 is formed.

On the surface (C plane) of the n⁺ type SiC layer 203 on the side opposite to the n⁻ type SiC layer 204, a nano-periodic structure 202 is formed. The nano-periodic structure 202 can be formed using the nano-periodic structure-forming apparatus 100 shown in Fig. 2. Furthermore, on the nano-periodic structure 202, an ohmic electrode 201 is formed.

For forming the nano-periodic structure 202, a femtosecond laser that generates a little heat is used and, therefore, it is possible to suppress an occurrence of influence on the structure having been formed due to high temperatures. Further, a good ohmic contact can be obtained by even only performing annealing at low temperatures instead of conventional high temperatures after forming the ohmic electrode 201 on the C plane. As a result, it is possible to furthermore suppress the precipitation of a C atom on the C plane due to high temperatures and the occurrence of influence on the structure having been formed due to high temperatures.

Fig. 5B is a schematic cross-sectional view of an exemplary horizontal type SBD 200b. In the horizontal type SBD 200b, a p⁻ type SiC layer 211 is stacked on a p type SiC layer 210. On the p⁻ type SiC layer 211, a first p type SiC barrier layer 212, an n type SiC channel layer 213, and a second p type SiC barrier layer 214 are stacked in this order. Meanwhile, contrary to the configuration, the channel layer may be formed of a p type and two barrier layers may be formed of an n type.

For the n type SiC channel layer 213 and the second p type SiC barrier layer 214, two recesses 218a, 218b are formed. In the recess 218a, a nano-periodic structure 216 is formed on the exposed surface of the n type SiC channel layer 213, and an ohmic electrode 215 that is in contact with the nano-periodic structure 216, the first p type SiC barrier layer 212 and the second p type SiC barrier layer 214 is formed. On the recess 218b, a Schottky electrode 217 that is in contact with the first p type SiC barrier layer 212, the n type SiC channel layer 213 and the second p type SiC barrier layer 214 is formed.

The nano-periodic structure 216 can be formed by removing the n type SiC channel layer 213 and the second p type SiC barrier layer 214 by etching to thereby form the recess 218a, and, after that, by irradiating the side wall of the recess 218a (that is, an exposed surface of the n type SiC channel layer 213) with a femtosecond laser using the nano-periodic structure-forming apparatus 100 shown in Fig. 2. As another method, it is also possible to perform ablation by irradiating vertically the n type SiC channel layer 213 and the second p type SiC barrier layer 214 with a femtosecond laser to thereby form the recess 218a and, as a result, to form the nano-periodic structure 216 on the side wall of the recess 218a.

For forming the nano-periodic structure 216, a femtosecond laser that generates a little heat is used and, therefore, it is possible to suppress an occurrence of influence on the structure having been formed due to high temperatures. Further, a good ohmic contact can be obtained by performing annealing at low temperatures instead of conventional high temperatures after forming the ohmic electrode 215. As a result, it is possible to furthermore suppress the occurrence of influence on the structure having been formed due to high temperatures.

Fig. 5C is a schematic cross-sectional view of an exemplary horizontal type field effect transistor (FET) 200c. In the horizontal type FET 200c, a p⁻ type SiC layer 221 is stacked on a p type SiC layer 220. On the p⁻ type SiC layer 221, a first p type SiC barrier layer 222, an n type SiC channel layer 223, and a second p type SiC barrier layer 224 are stacked in this order. Meanwhile, contrary to the configuration, the channel layer may be formed of a p type and two barrier layers may be formed of an n type.

For the n type SiC channel layer 223 and the second p type SiC barrier layer 224, two recesses 228a, 228b are formed. In the recess 228a, a nano-periodic structure 226a is formed on the exposed surface of the n type SiC channel layer 223, and a drain electrode 225 that is in contact with the nano-periodic structure 226a, the first p type SiC barrier layer 222 and the second p type SiC barrier layer 224 is formed. In the recess 228b, a nano-periodic structure 226b is formed on the exposed surface of the n type SiC channel layer 223, and a source electrode 227 that is in contact with the nano-periodic structure 226b, the first p type SiC barrier layer 222 and the second p type SiC barrier layer 224 is formed.

Further, between the drain electrode 225 and the source electrode 227, a Schottky gate electrode 229 that passes through the second p type SiC barrier layer 224 and contacts the n type SiC channel layer 223 is formed.

The nano-periodic structures 226a, 226b can be formed by removing the n type SiC channel layer 223 and the second p type SiC barrier layer 224 by etching to thereby form the recesses 228a, 228b, and, after that, by irradiating the side walls of recesses 228a, 228b (that is, an exposed surface of the n type SiC channel layer 223) with a femtosecond laser using the nano-periodic structure-forming apparatus 100 shown in Fig. 2. As another method, it is also possible to perform ablation by irradiating vertically the n type SiC channel layer 223 and the second p type SiC barrier layer 224 with a femtosecond laser to thereby form the recesses 228a, 228b and, as a result, to form the nano-periodic structures 226a, 226b on the side walls of the recesses 228a, 228b.

For forming the nano-periodic structures 226a, 226b, a femtosecond laser that generates a little heat is used and, therefore, it is possible to suppress an occurrence of influence on the structure having been formed due to high temperatures. Further, a good ohmic contact can be obtained by performing annealing at low temperatures instead of conventional high temperatures after forming the drain electrode 225 and the source electrode 227. As a result, it is possible to furthermore suppress the occurrence of influence on the structure having been formed due to high temperatures.

Configurations of device examples shown in Figs. 5A to 5C can appropriately be altered. In these device examples, SiC is used, but GaN or a diamond semiconductor may be used. The present invention is not limited to the application to the configuration described in the Description, but can be applied to any configuration that requires the formation of a metal film on a semiconductor and the formation of an ohmic contact.

This application claims the priority to the Japanese patent Application No. 2012-064707, filed on March 22, 2012, which is hereby incorporated by reference as a part of this application.

## Claims

1. A method of manufacturing a semiconductor device having a conductive film formed on a semiconducting substrate, the method comprising:
a surface modification step of irradiating a surface of the semiconducting substrate with a femtosecond laser to form a surface-modified region on the surface of the semiconducting substrate; and
a conductive-film forming step of forming the conductive film on the surface-modified region.

2. The method of manufacturing a semiconductor device according to claim 1, wherein the femtosecond laser has energy in a vicinity of a processing threshold value of the semiconducting substrate.

3. The method of manufacturing a semiconductor device according to claim 1 or 2, wherein the semiconducting substrate is an SiC substrate.

4. The method of manufacturing a semiconductor device according to any one of claims 1 to 3, wherein in the surface modification step, periodic irregularities are formed on the surface of the semiconducting substrate by irradiating the surface of the semiconducting substrate with the femtosecond laser.

5. The method of manufacturing a semiconductor device according to any one of claims 1 to 4, wherein in the surface modification step, a region having reduced surface resistance is formed on the surface of the semiconducting substrate by irradiating the surface of the semiconducting substrate with the femtosecond laser.

6. A semiconductor device comprising:
a semiconducting substrate;
a surface-modified region formed on a surface of the semiconducting substrate by irradiating the surface of the semiconducting substrate with a femtosecond laser; and
a conductive film formed on the surface-modified region.

7. The semiconductor device according to claim 6, wherein the femtosecond laser has energy in a vicinity of a processing threshold value of the semiconducting substrate.

8. The semiconductor device according to claim 6 or 7, wherein the semiconducting substrate is an SiC substrate.

9. The semiconductor device according to any one of claims 6 to 8, wherein the surface-modified region includes periodic irregularities formed on the surface of the semiconducting substrate, by irradiating the surface of the semiconducting substrate with the femtosecond laser.

10. The semiconductor device according to any one of claims 6 to 9, wherein the surface-modified region includes a region having reduced surface resistance formed on the surface of the semiconducting substrate, by irradiating the surface of the semiconducting substrate with the femtosecond laser.
